Europäisches Patentamt

European Patent Office

Office européen des brevets

(19)

(11) **EP 1 152 296 A1**

(12) **EUROPEAN PATENT APPLICATION**
published in accordance with Art. 158(3) EPC

(43) Date of publication:
**07.11.2001 Bulletin 2001/45**

(51) Int Cl.⁷: **G03F 7/095**, G03F 7/11,
G03F 7/00

(21) Application number: **00956836.1**

(22) Date of filing: **31.08.2000**

(86) International application number:
**PCT/JP00/05911**

(87) International publication number:
**WO 01/18605 (15.03.2001 Gazette 2001/11)**

(84) Designated Contracting States:
**AT BE CH CY DE DK ES FI FR GB GR IE IT LI LU
MC NL PT SE**

(30) Priority: **02.09.1999 JP 24840799**

(71) Applicant: **TORAY INDUSTRIES, INC.**
**Tokyo 103-8666 (JP)**

(72) Inventors:
• **Tanaka, Shinji**
**Okazaki-shi, Aichi 444-0932 (JP)**
• **Ichikawa, Michihiko**
**Okazaki-shi, Aichi 444-0932 (JP)**
• **Isono, Masanao**
**Okazaki-shi, Aichi 444-0864 (JP)**

(74) Representative: **Coleiro, Raymond**
**MEWBURN ELLIS**
**York House**
**23 Kingsway**
**London WC2B 6HP (GB)**

(54) **PHOTOSENSITIVE RESIN PRINTING PLATE AND METHOD FOR PRODUCING PHOTOSENSITIVE PRINTING PLATE HAVING PROJECTION**

(57) A photosensitive resin printing plate material capable of forming a relief image without requiring any original image film and yet, without contaminating the development solution, said photosensitive resin printing plate material comprising a support having provided thereon in the following order, at least a photosensitive resin layer, a film layer, and an optical density changing layer.

EP 1 152 296 A1

## Description

Field of the Invention

The present invention relates to a photosensitive resin printing plate material capable of forming photosensitive resin printing plates having relief, and to a method for producing photosensitive resin printing plates obtainable therefrom. The photosensitive resin printing plates thus obtained are usable as relief printing plates and flexographic printing plates.

Technical Background

Photosensitive resin compositions are generally used in the printing plates, and this is the main trend in the fields of relief printing, lithography, intaglio printing, and flexographic printing.

In the printing plate materials above, a negative or a positive original film is brought into close contact with a photosensitive resin layer, and an active ray is irradiated thereto through the original film to form, in the photosensitive resin layer, portions soluble and portions insoluble to the solvent. In this manner, a relief image is formed to provide a printing plate.

The printing plate material above requires not only a negative or a positive original film, but also a development process. Thus, the production of a single printing plate demanded many process steps and manpower.

With the progress in computer technology, there is proposed a method of producing relief printing plates and flexographic printing plates by directly outputting the information processed on the computer without incorporating the step of forming an original film.

More specifically, there is proposed methods as follows: (1) a method of forming an image on a photosensitive resin layer or on a thin film layer provided on a photosensitive resin layer by using a toner or a liquid ink, thereby excluding the use of original film (see, for example, JP-B-Sho58-20029 (the term "JP-A-" as referred herein signifies "an examined published Japanese patent application"), JP-A-Hei3-110164 (the term "JP-B-" as referred herein signifies "an unexamined published Japanese patent application"). JP-A-Hei10-10709, JP-A-Hei10-10710, etc.); (2) a method for directly obtaining a printing plate by irradiating a laser radiation to a porous material or a photosensitive layer to thereby melt or sublimate the irradiated portions (see, e.g., JP-A-Sho52-56601, JP-A-Sho53-127005, JP-B-Sho56-40033, JP-A-Sho61-106249, JP-Hyo-Hei7-505840, JP-Hyo-Hei7-506780, JP-A-Hei8-99478, JP-A-Hei8- 90947, JP-A-Hei9-142050, JP-A-Hei9-254351, etc.); or (3) a method comprising providing a thin film layer on the surface of the photosensitive resin, and forming a pattern on the thin film layer by using a laser, thereby excluding the use of original film (see, e.g., JP-A-Sho58-52646, Patent No. 2773847, Patent No. 2773981, JP-Hyo-Hei10-509254, JP-A-Hei8-305007, JP-A-Hei8-305030, JP-A-Hei9-171247, JP-A-Hei9-166875, JP-A-Hei10-39512, JP-A-Hei10-73917, etc.)

In the method (1) above, there is a problem as such that fine images cannot be formed, because a toner or a liquid ink is used to form the image. In the method (2), a laser radiation of high energy is irradiated to a porous material or a photosensitive layer. Hence, there is a problem as such that it is difficult to obtain a sharp image because the relief edge of the porous material or the photosensitive layer undergoes melting. Concerning the method (3), there generates a problem as such that the thin film layer component disperses into the development solution during the development step. This results in the problem of causing adhesion of the thin film component floating in the development solution to the surface of the photosensitive layer, or of requiring an additional step of processing the development solution at the disposal of the development solution.

Thus, in the light of the aforementioned problems, an object of the present invention is to propose a photosensitive resin printing plate material capable of forming a protruded relief image without requiring any original film, and yet, without contaminating the development solution.

Disclosure of the Invention

The present invention is a photosensitive resin printing plate comprising a support having provided thereon at least a photosensitive resin layer and an optical density changing layer, and a film layer being incorporated between the photosensitive resin layer and the optical density changing layer.

Furthermore, the method for producing a photosensitive resin printing plate having protruded portions according to the present invention comprises, at least the following steps in this order, a step of forming an image on the optical density changing layer, a step of forming a latent image by exposing the photosensitive resin layer through the image, a step of peeling off the film layer and the optical density changing layer from the photosensitive resin layer, and a step of developing the photosensitive resin layer.

Best Mode for Carrying Out the Invention

The photosensitive resin printing plate material according to the present invention has a constitution as such comprising a support, having provided thereon in the following order, at least a photosensitive resin layer, a film layer, and an optical density changing layer.

<Photosensitive Resin Layer>

The photosensitive resin layer according to the present invention is a layer which undergoes photo curing by irradiating a light having a wavelength in the range of from 300 to 400 nm. The photosensitive resin layer is obtained by forming a photosensitive resin composition into a sheet from 0.1 to 10 mm in thickness.

In general, the photosensitive resin composition above comprises at least an ethylenically unsaturated monomer and a photopolymerization initiator.

The ethylenically unsaturated monomer is a substance crosslinkable by radical polymerization. Thus, any substance crosslinkable by radical polymerization can be used without any limitations, but the following substances may be specifically mentioned; for instance, a compound having only one ethylenic unsaturated bond, for instance, a (meth)acrylate having a hydroxyl group, such as 2-hydroxyethyl (meth)acrylate, 2-hydroxypropyl (meth)acrylate, 2-hydroxybutyl (meth)acrylate, 3-chloro-2-hydroxypropyl (meth)acrylate, β-hydroxy-β'- (meth)acryloyl oxyethylphthalate, etc; an alkyl (meth)acrylate such as methyl (meth)acrylate, ethyl (meth)acrylate, propyl (meth)acrylate, butyl (meth) acrylate, isoamyl (meth)acrylate, 2-ethylhexyl (meth) acrylate, lauryl (meth)acrylate, stearyl (meth)acrylate, etc.; a cycloalkyl (meth)acrylate such as cyclohexyl (meth)acrylate, etc.; a halogenated alkyl (meth)acrylate such as chloroethyl (meth)acrylate, chloropropyl (meth) acrylate, etc.; an alkoxyalkyl (meth)acrylate such as methoxyethyl (meth)acrylate, ethoxyethyl (meth)acrylate, butoxyethyl (meth)acrylate, etc.; a phenoxyalkyl (meth)acrylate such as phenoxyethyl (meth)acrylate, nonylphenoxyethyl (meth)acrylate, etc.; an alkoxyalkyleneglycol (meth)acrylate such as ethoxydiethyleneglycol (meth)acrylate, methoxytriethyleneglycol (meth)acrylate, methoxydipropylene glycol (meth)acrylate, etc.; a (meth)acrylamide such as (meth)acrylamide, diacetone (meth)acrylamide, N,N'-methylene bis (meth)acrylamide, etc.; or 2,2-dimethylaminoethyl (meth)acrylate, 2,2-diethylaminoethyl (meth)acrylate, N,N-dimethylaminoethyl (meth)acrylamide, N,N-dimethylaminopropyl (meth)acrylamide, etc.; as well as a compound having 2 or more ethylenic unsaturated bonds, that is, for instance a di(meth)acrylate of polyethylene glycol such as diethylenediglycol di(meth)acrylate, etc.; a polypropyleneglycol di(meth)acrylate such as dipropylene di(meth)acrylate, etc.; or a polyfunctional (meth)acrylate such as trimethylolpropane tri(meth)acrylate, pentaerythritol tri(meth)acylate, pentaerythritol tetra(meth)acrylate, glycerol tri(meth)acrylate or compound obtained by addition reaction of ethyleneglycol diglycidylether with a compound containing both an ethylenically unsaturated bond and an active hydrogen such as an unsaturated carboxylic acid or an unsaturated alcohol; a polyfunctional (meth)acrylate obtained by addition reaction of an unsaturated epoxy compound such as glycidyl (meth)acrylate with a compound having an active hydrogen such as a carboxylic acid or an amine, etc.; a polyfunctional (meth)acrylamide such as methylene bis (meth) acrylamide, etc.; a polyfunctional vinyl compound such as divinyl benzene, etc.

There is no particular limitation on the photopolymerization initiator so long as it is a compound capable of polymerizing reactive carbon-carbon unsaturated groups by the irradiation of light. Among them, particularly preferred are those having a function of generating radicals by self decomposition or by hydrogen pulling out on the absorption of light, such as a benzoin alkyl ether, a benzophenone, an anthraquinone, a benzyl, an acetophenone or a diacetyl, etc.

In order to maintain the solid morphology of the photosensitive composition according to the present invention, an addition of a carrier resin is preferred. The carrier resins are used selectively depending on the ink used. In case of obtaining a printing plate material using an aqueous ink, used as the carrier resins are a general purpose rubber or elastomer such as a butadiene rubber, a nitrile rubber, an urethane rubber, an isoprene rubber, a styrene-butadiene rubber, a styrene-isoprene rubber, etc. In case of using an oil based ink, used are hydrophilic resin such as awater-soluble polyamide resin, a partially saponified poly(vinyl acetate), etc.

As other components, there can also be added a compatibility agent to improve the compatibility and flexibility, such as a polyhydric alcohol, e.g., ethylene glycol, diethylene glycol, triethylene glycol, glycerol, trimethylolpropane, trimethylolethane, etc., as well as a liquid rubber such as liquid polybutadiene, liquid polyisoprene, etc. To improve thermal stability, there may be added a polymerization inhibitor conventionally known in the art. A preferred polymerization inhibitor includes a phenol, a hydroquinone, a catechol, etc. Furthermore, there can be added a dye, a pigment, a surface activating agent, an ultraviolet radiation absorbing agent, a perfume, an oxidation preventive agent, etc.

A method for obtaining a photosensitive resin layer from the photosensitive resin composition containing the carrier resin comprises, for instance, dissolving the carrier resin in a solvent capable of dissolving the resin, obtaining a solution of the photosensitive resin composition by thoroughly stirring a mixture of an ethylenically unsaturated monomer with a photopolymerization initiator, and after removing the solvent from the solution, melt-extruding the resulting product on a support coated with an adhesive. Otherwise, there can be employed a method comprising spreading the solution of the photosensitive resin composition containing the solvent on a support coated with an adhesive, followed by removing the solvent by drying.

<Support>

The support for use in the present invention refers to a metal such as a steel, a stainless steel, aluminum, etc.; a plastic sheet such as of polyester; or a synthetic rubber sheet such as of styrene-butadiene rubber.

The thickness of the support differs depending on the desired use; in general, the thickness is in a range of from 0.1 mm to 10 mm.

<Film Layer>

The film layer according to the present invention is not particularly limited so long as it is a thermoplastic film capable of transmitting ultraviolet radiation. More specifically, usable are a polyethylene film, a polypropylene film, a polyethylene terephthalate film, a polybutyrene terephthalate film, etc.

The thickness of the film layers above is preferably in a range of from 1 to 30 μm, and more preferably, from 6 to 20 μm. A film 1 μm or more in thickness can be suitably used because such a film can be stripped from the photosensitive resin layer without any breakage; on the other hand, a film 30 μm or less in thickness is also suited because the relief image that is formed on the photosensitive resin layer on exposure through the film can be obtained without causing any blurring.

To improve the adhesiveness between the optical density changing layer and the film layer, a surface roughening treatment can be applied to the surface of the film layer faced opposed to the optical density changing layer so long as the transparency of the film layer is preserved.

As the surface roughening treatment of the film layer, there can be applied known methods. More specifically, for instance, there can be mentioned EC treatment, corona treatment, plasma treatment, irradiation of an electron beam, Xray irradiation treatment, solvent treatment, or a mechanical emboss processing or sand blasting, as well as a crystallization acceleration treatment, an addition of a crystallization accelerating agent to the film, an addition of inorganic particles or an organic polymer immiscible with the film layer, or applying a coating to a smoothed surface of the film by using a paint containing inorganic particles or an organic polymer.

<Adhesive Layer>

Furthermore, if necessary, an adhesive layer can be provided on the surface-roughened or untreated film layer. As the adhesive layer, there can be used an organic titanate or a silane coupling agent, or an epoxyresin, a polyurethane resin, a polyester resin, an urea resin an acrylic resin, or a mixture containing two types or more selected therefrom.

As the silane coupling agent, usable are those well known in the art, such as vinylsilane, (meth)acryloylsilane, epoxysilane, aminosilane, mercaptosilane, chlorosilane, etc., but preferred among them are (meth) acryloylsilane, epoxysilane, aminesilane, and mercaptosilane. The silane coupling agents above can be applied by coating the substrate with a dilute solution obtained by dissolving the silane coupling agent to a proper solvent, followed by thermal curing, or by using an evaporation method. A film provided at a thickness corresponding to about a single molecule of the silane coupling agent layer is sufficient; more specifically, the film is preferably provided at a thickness of 500 Angstroms or less, and more preferably, 100 Angstroms or less. If the film thickness exceeds 500 Angstroms, the adhesiveness of the film to the optical density changing layer becomes inferior.

<Optical Density Changing Layer>

The optical density changing layer according to the present invention is a layer whose optical density changes in accordance with the irradiation of a laser radiation.

The optical density as referred in the optical density changing layer according to the present invention is generally expressed by D as defined by the following equation:

$$D = \log_{10} O = \log_{10} (1/T) = \log_{10} (I_0/I)$$

where, $O = I_0/I$ represents the blackness, T represents the transmittance, $I_0$ represents the intensity of the incident light on measuring the transmittance, and I represents the intensity of transmitted light.

For the measurement of the optical density, there is known a calculation method comprising performing the measurement of the intensity of transmitted light, and a calculation method by performing the measurement of the intensity of the incident light. The optical density in the case of the present invention is the calculated value obtained from the intensity of the transmitted light.

The optical density above can be measured by, for instance, using a Macbeth transmission densitometer, "TR-927" (manufactured by Kollmorgen Instruments Corporation), together with an orthomatic filter.

The optical density changing layer is characterized by that it yields an optical density of 2.0 or greater or 0.5 or lower before the irradiation of a laser radiation, which changes to 0.5 or lower or 2.0 or greater after the irradiation of a laser radiation.

In case an optical density of 2.0 or greater is obtained, the layer functions as practically cutting off the ultraviolet radiation, and if the layer yields an optical density of 0.5 or lower, the layer practically transmits ultraviolet radiation.

As the laser to be used, there is no particular limitation so long as it is capable of causing a change in optical density in the optical density changing layer, but suitably used are those emitting a visible radiation or an infrared radiation, and particularly suited is an infrared-emitting laser.

As a method for changing the optical density by using a laser radiation, there can be mentioned methods as follows: (Method 1) a method comprising forming a layer of a composition as the optical density changing layer by using a composition containing a metal oxide or a composition containing an easily heat-decomposable compound and a light-to-heat converting substance, or forming a thin film layer of carbon and the like, followed by irradiating a laser radiation to allow the composition to undergo evaporation or discoloration, thereby causing a change in optical density, and (Method 2) a method comprising forming a composition layer which changes its color on irradiating a laser radiation, followed by irradiating a laser radiation to change the color thereof, thereby causing a change in optical density.

Firstly, (Method 1) is described below.

The optical density changing layer in this case yields an optical density of 2.0 or higher before irradiating a laser radiation, which optical density of the laser irradiated portions drops to 0.5 or lower.

Such a layer having an optical density of 2.0 or higher can be obtained by coating, or by evaporation or sputtering.

In case of forming an optical density changing layer by coating, a composition containing ametal oxide, or a composition containing a compound which easily undergoes thermal decomposition and a light-to-heat converting substance, can be mentioned as the coating composition.

As a preferred compound which easily undergoes thermal decomposition, there can be mentioned a nitro compound such as ammonium nitrate, potassium nitrate, sodium nitrate, nitrocellulose, etc., an organic peroxide, polyvinyl pyrrolidone, an azo compound, a diazo compound, or a hydrazine derivative, but particularly preferred among them from the viewpoint of applicability is a polymer compound such as polyvinyl pyrrolidone and nitrocellulose.

In case of using nitrocellulose, the viscosity of nitrocellulose is preferably such yielding a value in the range of 1/16 to 1 second, and more preferably, in a range of from 1/8 to 1/2 second, as measured in accordance with the measurement method standardized in ASTMD301-72. The viscosity corresponds to the polymerization degree of nitrocellulose, and a low viscosity signifies a low polymerization degree. If the viscosity is higher than 1/16 second, nitrocellulose having a sufficiently high degree of polymerization can be obtained. Thus, the surface of the optical density layer having high optical density can be maintained without generating any scratches. If the viscosity is lower than 1 second, on the other hand, the inconvenience attributed to high viscosity can be eliminated.

The quantity of polyvinyl pyrrolidone or nitrocellulose to be incorporated in the optical density changing layer as referred above preferably accounts for 80 % by weight or less, and more preferably, 10 to 60 % by weight, with respect to the total weight of the composition constituting the optical density changing layer. If the quantity is maintained at a quantity of 80 % by weight or less, the problem of insufficient decomposition of the easily heat decomposable substance, which occurs more frequently with decreasing quantity of light-to-heat converting substance mentioned below, can be prevented from occurring.

Preferably, a light-to-heat converting substance is incorporated, so that the thermal decomposition reaction may occur efficiently on irradiating a laser radiation to the easily heat decomposable compound.

As substances for use as the light-to-heat converting substance, there is no particular limitation so long as the substance absorbs light and converts the radiation energy to heat. Examples of such substances include, for instance, a black colored pigment such as carbon black, aniline black, cyanine black, etc.; a green colored pigment such as phthalocyanine or napthalocyanine, etc.; a rhodamine dye, an aminium salt, naphthoquinone, a polymethine dye, a diimonium salt, an azoimonium based coloring matter, a calcogen based coloring matter, carbon graphite, iron powder, a diamine based metal complex, a dithiol based metal complex, a phenolthiol based metal complex, a mercaptophenol based metal complex, an arylaluminum metallic salt, an inorganic compound containing crystal water, copper sulfate, chromium sulfide, a silicate compound, metal oxides such as titanium oxide, vanadium oxide, manganese oxide, iron oxide, cobalt oxide, tungsten oxide, etc.; hydroxides and sulfates of the metals enumerated in the above oxides; or metallic powders of bismuth, tin, tellurium, iron, aluminum, etc. Preferably, the additives above are added as the light-to-heat converting substance.

In addition to the substances above, dyes are also useful as a light-to-heat converting substance. In particular, an azine based dye is useful; as a part of the specific examples, there can be mentioned "Nigrosine" (manufactured by Ikeda Kagaku Kogyo K.K.), "Spirit Black SB", "Spirit Black AB", "Bari First Black" 3810 and 3820 (manufactured by Orient Chemicals, Co., Ltd.), "SPIRIT NIGROCINE" SJ (manufactured by DYE SPECIALITIES, Inc.)

The use of the azine based dyes in combination with an infrared absorbing agent is particularly preferred.

Among them, from the viewpoint of light-to-heat converting efficiency, from economical point of view, and in view of handling properties, particularly preferred is carbon black. Concerning the method of production, carbon black can be further classified into furnace black, channel black, thermal black, acetylene black, lamp black, etc., but preferably used is furnace black, because it is commercially available at a low cost in a variety types concerning, for instance, particle size, etc.

Similar to carbon black, the dyes above are favorably utilized because of their advantage concerning the dispersibility and coating properties of the painting solution in case of providing the optical density changing layer.

The quantity of the light-to-heat converting substances is such preferably accounting for 2 to 75 % by weight, and more preferably, 5 to 70 % by weight, with respect to the total weight of the composition constituting the optical density changing layer. If the light-to-heat converting substance is incorporated at an amount of more than 2 % by weight, the light-to-heat converting can be performed efficiently, and if it is incorporated at an amount less than 75 % by weight, the problem that the layer having high optical density layer is apt to scratches, or that the film layer tends to cause adhesion failure can be circumvented.

It is also effective to add a heat decomposition aid, such as urea or an urea derivative, zinc white, lead carbonate, lead stearate, glycolic acid, etc.

In using the heat decomposition aids above, the added quantity is preferably at an amount of 0.02 to 10 % by weight, more preferably, at an amount of 0.1 to 5 % by weight, with respect to the total photosensitive layer composition.

Preferably, a binder resin is added to prevent surface cracks from generating on the surface of the optical density changing layer. More specifically, usable as the binder resins are an epoxy resin, a melamine resin, an urethane resin, a polyester resin, a polyamide resin, etc. These resins can be used in combination thereof.

The binder resins above are preferably added at an amount of 60 % by weight or less, with respect to the total weight of the composition constituting the optical density changing layer. If the binder resin is incorporated at an amount exceeding 60 % by weight, the heat decomposition of the optical density changing layer may not be carried out efficiently.

The optical density changing layer according to the present invention requires an optical density of 2.0or higher to cut off an ultraviolet radiation. Thus, the optical density changing layer must contain a colorant. However, in case the layer becomes colored by the selective absorption of the visible rays and ultraviolet rays by the light-to-heat converting substance above to yield the desired optical density, there is no need of incorporating a colorant.

The optical density changing layer obtained by the coating process as described above is preferably provided at a thickness of from 0.5 or 100 μm, and more preferably, at a thickness of from 1 to 50 μm. In case the optical density changing layer is provided at a thickness of 0.5 μm or thicker, the surface scratches less tend to be generated and light leakage less tends to occur, thereby resulting in the implementation of an optical density changing layer having a constant optical density without requiring skilled technique in coating. If the layer is provided at a thickness of 100 μm or less, it results in a reduced cost because the change in optical density can be realized without requiring high energy.

The optical density changing layer may be a thin film layer if it substantially non-transparent for an ultraviolet radiation. Such thin films are preferably formed by vacuum evaporation or sputtering.

In general, vacuum evaporation is carried out inside a reduced pressure vessel maintained at a vacuum degree of from $10^{-4}$ to $10^{-7}$ mmHg, by forming a thin film on the surface of the substrate by heating and vaporizing a metal and carbon.

In case of using sputtering, a direct current or an alternating current is applied to a pair of electrodes provided in a reduced pressure vessel maintained at a vacuum degree of from $10^{-1}$ to $10^{-3}$ mmHg, thereby generating glow discharge and taking advantage of the sputtering phenomenon of the cathode to form a thin film on a substrate.

As a thin film layer capable of providing the optical density required in the present invention, a thin film layer of carbon can be preferentially mentioned. The carbon thin film as referred herein is not a so-called diamond thin film or a graphite thin film, but is a thin film of amorphous carbon. An amorphous carbon thin film can be obtained, nearly selectively, by a general vacuum evaporation method such as ion beam evaporation or ionized evaporation, or by a sputtering process such as ion beam sputtering.

As the method for forming a carbon thin film, there can be employed either a vacuum evaporation method or a sputtering method.

In general, a vacuum evaporation of the carbon thin film is carried by forming a thin film on the surface of the substrate by heating and evaporating carbon inside a reduced pressure vessel maintained at a vacuum degree of from $10^{-4}$ to $10^{-7}$ mmHg. In this case, the heating temperature of carbon is set higher and the time duration of vapor evaporation is set longer, because the melting point of carbon at ordinary pressure is as high as 3923 K.

In case of forming a carbon thin film by sputtering, a thin film is formed on the substrate by applying a direct current or an alternating current to a pair of electrodes provided in a reduced pressure vessel maintained at a vacuum degree of from $10^{-1}$ to $10^{-3}$ mmHg, thereby generating glow discharge and taking advantage of the sputtering phenomenon of the cathode. In this method, a thin film can be formed relatively easily even in case of carbon having such a high melting point.

As a thin film capable of providing an optical density changing layer other than a thin film of carbon, there can be mentioned a thin film of a metal. As non-limiting specific examples of such metals, there can be mentioned, for instance, tellurium, tin, antimony, gallium, magnesium, polonium, selenium, thallium, zinc, aluminum, silicon, germanium, copper, iron, molybdenum, nichrome, indium, iridium, manganese, lead, phosphorus, bismuth, nickel, titanium, cobalt, rhodium, osmium, mercury, barium, palladium, a compound described in JP-B-Sho41-14510, such as silicon carbide, boron nitride, boron phosphide, aluminum phosphide, an alloy of antimony and aluminum, an alloy of gallium and phosphorus, an alloy of gallium and antimony, etc. Preferred among them are tellurium, tin, antimony, gallium, magnesium, polonium, selenium, thallium, zinc, bismuth, and aluminum.

The reflection of a laser radiation occurs stronger with increasing metallic luster of the surface. Accordingly, from the viewpoint of sensitivity, the use of a material having less metallic luster is preferred.

As a metal which partially or wholly undergoes instantaneous evaporation or melting, any metal having a melting point of 2000 K or lower can be used. If the metal should have a melting point exceeding 2000 K, some time takes to evaporate or melt the metal even if a laser radiation is irradiated thereto, and this decreases the sensitivity of the plate material.

Concerning the melting point, preferred are the use of metals having a melting point of 1000 K or lower. More specifically, preferably used are tellurium, tin, antimony, gallium, magnesium, polonium, selenium, thallium, zinc, and bismuth, and more preferably, there can be mentioned tellurium, tin, or zinc. These metals are particularly preferred because they easily undergo evaporation or melting with heat in case a laser radiation is irradiated to the thin film.

These metals are particularly preferred because the melting point further drops and the sensitivity increases by alloying two or three types of metals selected therefrom. More specifically, preferred are an alloy of tellurium and tin, tellurium and antimony, tellurium and gallium, tellurium and bismuth, or tellurium and zinc. More preferably used are an alloy of tellurium and zinc or of tellurium and tin. As an alloy containing three types of metals, preferably used are an alloy of tellurium, tin, and zinc, an alloy of tellurium, gallium, and zinc, an alloy of tin, antimony, and zinc, or an alloy of tin, bismuth, and zinc, and more preferred among them is an alloy of tellurium, tin, and zinc, or an alloy of tin, bismuth, and zinc.

The thin films of the metals above are preferably formed preferably by vacuum evaporation or sputtering.

Furthermore, as a thin film providing the optical density changing layer, also usable is a thin film layer containing carbon and a metal. The optical density increases by simultaneously evaporating or sputtering carbon and the metal as to advantageously provide a layer capable of absorbing an infrared radiation or a laser radiation.

As a result, many types of metals can be used as the heat sensitive layer.

Any metal or alloy capable of being vapor evaporated or sputtered may be used without any limitations, but preferred are the metals having a melting point of 2000 K or lower, and more preferred are those having a melting point of 1000 K or lower. If the melting point should be higher than 2000 K, an image would not be formed easily even if carbon should be vapor evaporated or sputtered simultaneously with the metal.

In case of simultaneously evaporating or sputtering the metals above with carbon, carbon preferably accounts for 10 % by weight or more, more preferably, 30 % by weight or more, of the thin film thus formed. If carbon should account for less than 10 % by weight, the absorbance for infrared laser radiation decreases as to result in a decreased sensitivity.

Furthermore, the film thickness of the thin film greatly influences the sensitivity. That is, if the film is provided too thick, more energy is required to evaporate and melt the thin film. This leads to a drop in sensitivity of the plate material. Accordingly, a film thickness of 1000 Angstrom or less is preferred for the thin film; more preferably, the thin film is provided at a film thickness of 20 to 1000 Angstrom, and most preferably, it is provided at a film thickness of 40 to 200 Angstrom. If the film should be provided at a thickness of less than 20 Angstrom, the sensitivity is reversely impaired.

Next, (Method 2) is described below.

The optical density changing layer for use in method 2 yields an optical density of 0.5 or lower before irradiating a laser radiation, but it changes to 2.0 or higher after irradiating the laser radiation.

The optical density changing layer above can be obtained, in general, by forming a layer of a light-to-heat converting substance and a thermally coloring layer, or by forming a layer formed by mixing the substances constituting the light-to-heat converting layer and the thermally coloring layer.

The layer of a light-to-heat converting substance above is a layer which generates heat by absorbing a laser radiation. Such substances include coloring matters, particularly dyes, which is transparent and transmits light in the wavelength range of from 300 to 400 nm, but which absorbs an infrared radiation or a near infrared radiation. Particularly preferred are the coloring matters, particularly the dyes, which are based on cyanine, phthalocyanine, naphthalocyanine, dithiol metal complexes, piazulenium, squarium, chroconium, azo based dispersion colorants, bisazo, bisazostylbene, naphthoquinone, anthraquinone, perylene, polymethine, indoaniline metal complex dyes, intermolecular type CT coloring matters, benzothiopyran, spiropyran, nigrosine, thioindigo, nitroso, quinoline, and flugido.

Preferred among them from the viewpoint of absorbance of laser radiation are the cyanine, polymethine, and naphthalocyanine dyes.

The compounds which absorb a laser radiation and generate heat are incorporated at an amount accounting for 1 to 40 % by weight, more preferably, 5 to 25 % by weight, with respect to the solid content of the composition constituting the light-to-heat converting substance layer. By incorporating the compounds above at an amount of 1 % by weight or higher and by setting the upper limit to 40 % by weight, the laser absorption can be effected more efficiently without disadvantageously affecting the physical properties of the composition constituting the layer of the light-to-heat converting substance.

In general, a carrier resin is incorporated in the composition constituting the light-to-heat converting layer. The resin for use in the light-to-heat converting layer is not particularly limited, but there can be specifically mentioned, for instance, polyvinyl alcohol, polyvinyl acetate, partially saponified polyvinyl acetate, cellulose resins, acrylic resins, polyvinyl pyrrolidone, nylon resins, urethane resins, ethylene-vinyl acetate copolymers, polybutadiene, polyisoprene, styrene-butadiene rubbers, nitrile rubbers, etc.

The carrier resins are preferably incorporated in the composition constituting the light-to-heat converting substance layer at an amount accounting for 20 to 99 % by weight, and more preferably, 30 to 60 % by weight. By incorporating the carrier resins at an amount accounting for 20 % or more by weight and setting the upper limit to 99 % by weight, the morphology of the light-to-heat converting layer can be maintained without unfavorably affecting the light-to-heat converting efficiency.

As another component to be included in the light-to-heat converting substance layer, a plasticizer may be incorporated if necessary. As such plasticizers, there can be mentioned glycols, such as ethylene glycol, diethylene glycol, triethylene glycol, etc.; polyalkylene glycols such as polyethylene glycol, polypropylene glycol, etc.; or liquid rubbers such as liquid butadiene, liquid isoprene rubber.

The thickness of the light-to-heat converting layer is not particularly limited so long as it has a sufficiently high heat-generating function, but preferably, the thickness of the layer is in a range of from 0.1 to 30 $\mu$m.

The thermally coloring layer according to the present invention is a layer capable of transmitting an ultraviolet radiation before it is heated, but which becomes colored by heating as to substantially cut off the transmission of an ultraviolet radiation. There is no particular limitation on the layer so long as it exhibits the function above, but generally known is that such a function can be realized by incorporating a coloring agent and a developing agent. For instance, such a function can be realized by using the substances disclosed in, for example, JP-A-Sho61-121875, JP-A-Heil-99873, and JP-A-Hei5-104859.

The thermally coloring layer is a layer which becomes colored by heating. In general, the thermally coloring layer can be obtained by incorporating a coloring agent and a developing agent.

As the coloring agents, there can be used those known in the art. For instance, there can be preferably used leuco compounds, for instance, triphenylmethane phthalide compounds, triallylmethane compounds, phenothiazine compounds, thioferuolan compounds, xanthene compounds, indophthalyl compounds, spiropyran compounds, azaphthalide compounds, chromenopyrazole compounds, methine compounds, rhodamine anilinolactam compounds, rhodamine lactam compounds, quinazoline compounds, diazoxanthene compounds, and bislactone compounds.

As the developing agents, there can be mentioned phenolic compounds, thiophenolic compounds, thiourea derivatives, organic acids and the metal salts thereof, dibasic acids, and organic phosphate compounds.

In general, a carrier resin is mixed to fix the coloring agent and the developing agent. Although there is no particular limitation on the carrier resin, specifically mentioned are, for instance, polyvinyl alcohol, polyvinyl acetate, partially saponified polyvinyl acetate, cellulose resins, acrylic resins, polyvinyl pyrrolidone, nylon, urethane resins, ethylene-vinyl acetate copolymers, polybutadiene, polyisoprene, styrene-butadiene rubbers, nitrile rubbers, etc. However, the carrier resin is not only limited thereto. Further, if necessary, a plasticizer or a coloration inhibitor may also be incorporated.

The thickness of the thermally coloring layer is not particularly limited so long as the layer exhibits a function of substantially prohibiting the transmittance of an ultraviolet radiation on coloring, but preferably, it is in a range of from 0.1 to 30 $\mu$m. If the layer is provided at a thickness of 0.1 $\mu$m or more, the layer after infrared radiation is capable of preventing the transmittance of the ultraviolet radiation, and if the layer is provided at a thickness of 30 $\mu$m or less, the absorption of an ultraviolet radiation can be suppressed to a low level. Hence, the thickness range above is preferred.

<Method for Producing the Photosensitive Resin Printing Plate Material>

A photosensitive resin printing plate material can be obtained by a method comprising forming an optical density changing layer on a film layer, followed by pressure adhering them to a photosensitive resin layer formed on the support above by using a press under heating or without heating, or by laminating them using a roll under heating or without heating. In this manner, there can be obtained a photosensitive resin printing plate material comprising a support provided thereon a photosensitive resin layer, a film layer, and an optical density changing layer in this order.

If necessary, a film stripping layer may be provided between the photosensitive resin layer and the film layer. The function of this layer is to facilitate peeling off the film layer from the photosensitive resin layer.

The degree how the film stripping layer facilitates the peeling off of the film can be expressed by the peel strength on peeling off the film. In case of peeling off the film from the photosensitive resin layer at a speed of 200 mm/min, the peel strength is preferably in a range of from 0.5 to 20 g/cm, more preferably, in a range of from 1 to 15 g/cm, per 1 cm of the covering film.

A peel strength of 0.5 g/cm or higher is preferred because the peeling off of the film can be operated without separating the cover film during processing operation, and a peel strength of 20 g/cm or lower is preferred because the cover film can be peeled off without causing any inconveniences.

The substance constituting the film stripping layer is not particularly limited so long as the conditions above are satisfied. As specific examples for use in the film stripping layer, there can be mentioned resins such as polyvinyl alcohol, partially saponified polyvinyl acetate, polyamide resins, ethylene-vinyl acetate copolymers, cellulose, etc. The resins above can be used in combination of two or more selected therefrom, or may be constituted from two layers or more of the resins above.

The film stripping layer is preferably provided at a thickness of from 0.2 to 20 μm. A thickness of 0.2 μm or more is preferred because a stable peel strength can be obtained without being influenced by the substance constituting the photosensitive resin layer, and a thickness of 20 μm or less is preferred because a favorable image formation can be implemented on the photosensitive resin layer.

The film stripping layer can be formed by beforehand coating the surface of the film layer using a slit dye coater, a gravure coater, a reverse coater, or by incorporating the resin constituting the film stripping layer between the film layer and the photosensitive layer during hot pressing or hot laminating them.

Then, if necessary, a protective layer may be provided on the optical density changing layer. This layer functions as to protect the optical density changing layer. By providing this layer, problems such as causing failure in forming the desired image due to the generation of flaws on the surface of the optical density changing layer during the operation, etc., can be prevented from occurring.

There is no particular limitation for the protective layer so long as it exhibits a function of protecting the optical density changing layer, but in general, favorably used are films such as a polyethylene terephthalate film or a polybutyrene terephthalate film, or a resin film obtained by coating resins such as an epoxy resin, a polyester resin, a nylon, a urethane resin, etc.

In case the protective layer is a film, it is preferably provided at a thickness of 50 to 200 μm. A film provided at a thickness of 50 μm or thicker is preferred because it sufficiently exhibit a protecting function, and a film provided at a thickness of 200 μm or thinner is preferred because the protective layer can be easily peeled off at the time of usage. In case a resin coating film is used as the protective layer, it is preferably provided at a thickness of 2 to 50 μm. A coated film provided at a thickness of 2 μm or thicker is preferred because it can sufficiently exhibit a protecting function, and a film provided at a thickness of 50 μm or thinner is preferred because the protective layer can be provided with a sufficiently low bending strength suitable for use.

<Method of Producing a Photosensitive Resin Printing Plate>

A photosensitive resin printing plate having a relief provided thereon can be produced from the photosensitive resin printing plate material obtained above in the following manner.

The photosensitive resin printing plate having a relief provided thereon according to the present invention comprises, in the following order, at least a step of forming an image film on the optical density changing layer, a step of forming alatent image by exposing the photosensitive resin layer through the image obtained above, a step of peeling off the film layer and the optical density changing layer from the photosensitive resin layer, and a step of developing the photosensitive resin layer.

The step of forming an image on the optical density changing layer comprises, irradiating a laser radiation image-wise to the optical density changing layer, in case a film is attached as the protective layer after peeling off the film. A difference in optical density generates on the portions depending on whether the laser radiation was irradiated or not. Thus, a portion having a high optical density yields a value of 2.0 or higher, whereas a portion of low optical density yields a value of 0.5 or lower. An ordinary laser radiation source is used on irradiating a laser radiation, and usable as the radiation source are a variety of lasers emitting a radiation in a wavelength region of from 300 to 1500 nm, such as an Ar ion laser, a Kr ion laser, a He-Ne laser, a He-Cd laser, a ruby laser, a glass laser, a semiconductor laser, a YAG laser, a titanium sapphire laser, a dye laser, a nitrogen laser, a metal vapor laser, etc. Particularly preferred among them is a semiconductor laser, because, in view of the recent technological progress, it is provided more compact and with economical advantage as compared with the other laser radiation sources. The energy of the laser for patterning the image on the optical density changing layer is not particularly limited, but preferably, it is in a range of from 400 mJ/cm$^2$ to 5000 mJ/cm$^2$.

The step of forming a latent image by exposing the photosensitive resin layer through the image comprises irradiating a light, generally having a wavelength in the range of from 300 to 400 nm, to the laser-irradiated photosensitive resin printing plate material above, on the entire surface through the optical density changing layer having formed therein an image by using a laser. In this case, the side planes are preferably provided with a cover that cuts off the irradiated light, because the irradiated light enters to the photosensitive resin printing plate material through the side planes. As a light source capable of irradiating a radiation 300 to 400 nm in wavelength, generally used are a high pressure mercury lamp, a ultra high pressure mercury lamp, a metal halide lamp, a xenon lamp, a carbon arc lamp, a chemical lamp, etc. The portion of the photosensitive resin layer irradiated with the irradiation light changes into a substance that remains in the development solution without being eluted and dispersed.

The step of peeling off the film layer and the optical density changing layer from the photosensitive resin layer comprises peeling off the film layer and the optical density changing layer from the photosensitive resin layer to expose the surface of the photosensitive resin. The layers may be peeled off either manually, or mechanically.

The step of developing the photosensitive resin layer comprises developing the photosensitive resin layer by attaching it to a brush type washing machine or a spray type washing machine equipped with a developing solution which dissolves and disperses the photosensitive resin layer. The portion irradiated with the irradiation light is left over to form the relief image.

Then, if necessary, the photosensitive resin printing plate material is subjected to drying, post exposure, and removal of the adhesives to thereby obtain a photosensitive resin printing plate which can be readily mounted on a printing machine.

EXAMPLES

The present invention is described in further detail by way of examples.

The compositions for each of the layers and the method for producing them are described below.

1. Film layer

Film layer 1: Polyethylene terephthalate film (8 μm in thickness) ("Lumirror", manufactured by Toray Industries, Inc.)
Film layer 2: Polyethylene terephthalate film (50 μm in thickness) ("Lumirror", manufactured by Toray Industries, Inc.)
Film layer 3: Polypropylene film (6 μm in thickness) ("Torayfan", manufactured by Toray Industries, Inc.)

2. Optical density changing layer composition

Optical density changing layer composition 1

The following components were mixed at room temperature to obtain a homogeneous solution:

(a) Carbon black (MA100, manufactured by Mitsubishi Chemical Corporation    24 parts by weight
(b) Nitrocellulose    27 parts by weight
(c) Epoxy resin ("EPICOAT" 828, manufactured by Yuka-Shell Epoxy Co., Ltd.)    15 parts by weight
(d) Melamine resin ("U-VAN" 2061, manufactured by Mitsui Chemicals Co., Ltd.)    14 parts by weight
(e) Acrylic ester ("Light Acrylate" 3EG-A, manufactured by Kyoeisha Co., Ltd.)    10 parts by weight
(f) N,N-dimethylformamide    100 parts by weight
(g) Methyl Isobutyl Ketone    370 parts by weight

Optical density changing layer 2

The following components were mixed at room temperature to obtain a homogeneous solution:

(a) Polyvinyl pyrrolidone ("K-120", manufactured by ISP Japan Co. Ltd.)    40 parts by weight
(b) Polymethine dye ("KAYASORB" IR820(B), manufactured by NIPPON KAYAKU Co., Ltd.)    5 parts by weight
(c) Azine dye ("SPIRIT NIGROCINE" SJ, manufactured by DYE SPECIALITIES Inc.)    60 parts by weight
(d) Methyl Ethyl    250 parts by weight
(e) Methanol    100 parts by weight
(f) Methyl cellosolve    200 parts by weight

Optical density changing layer 3

A. light-to heat converting substance layer composition
The following components were mixed at room temperature to obtain a homogeneous solution:

(a) Polyvinyl pyrrolidone ("K-120", manufactured by ISP Japan Co. Ltd.)    40 parts by weight
(b) Polymethine dye ("KAYASORB" IR820(B), manufactured by NIPPON KAYAKU Co., Ltd.)    5 parts by weight
(c) Methyl Ethyl Ketone    250 parts by weight
(d) Methanol    100 parts by weight
(e) Methyl cellosolve    200 parts by weight

B. Thermally coloring layer composition
The following components were mixed at room temperature to obtain a homogeneous solution:

(a) 3-(N-isoamyl-N-ethylamine)-7,8-benzfluoran    10 parts by weight
(b) Octadecylphosphonic acid    30 parts by weight
(c) Vinyl chloride-vinyl acetate copolymer    30 parts by weight
(d) Toluene    135 parts by weight
(e) Methyl Ethyl Ketone    135 parts by weight

3. Photosensitive resin Layer Composition

Photosensitive resin Layer Composition 1

Acrylonitrile was added to both terminals of polyethylene glycol having a number molecular weight of 600, and the resulting product was reduced with hydrogen to obtain α,ω-diaminopolyoxyethylene. Thus, 60 parts by weight of an equimolar salt of a, ω-diaminopolyoxyethylene with adipic acid, 20 parts by weight of ε-caprolactam, and 20 parts by weight of an equimolar salt of hexamethylene diamine with adipic acid were melt polymerized under the ordinary conditions to obtain a polyamide having a relative viscosity (measured at 25 °C on a solution obtained by dissolving 1 g of the polymer in 100 ml of chloral hydrate) of 2.50.

A photosensitive resin composition comprising components as follows:

(a) Polyamide obtained above      50 parts by weight
(b) An ethylenically unsaturated compound, which is an addition reaction product of 1 mol of glycidyl methacrylate and 1 mol of acrylic acid      30 parts by weight
(c) An addition polymerization product of 1 mol of propylene glycol diglycidyl ether and 2 mol of acrylic acid      15 parts by weight
(d) Diethylene glycol      5 parts by weight
(e) Dimethyl benzyl ketal      1 part by weight
(f) Hydroquinone monomethyl ether      0.01 parts by weight
(g) Water      30 parts by weight
(h) Ethanol      70 parts by weight

Photosensitive resin layer composition 2

Raw materials, i.e., 100 parts by weight of water, sodium dodecylbenzenesulfonate, 3 parts by weight of polyoxyethylene nonyl phenyl ether, 0.3 parts by weight of potassium persulfate, 0.2 parts by weight of t-dodecyl mercaptan, 29 parts by weight of methyl methacrylate, 1 part by weight of methacrylic acid, and 70 parts by weight of butadiene, were reacted at 50 °C for 20 hours to obtain "water-dispersed latex rubber 1" having a number average particle diameter of 140 nm, a glass transition temperature of -52 °C, and a solid concentration of 50.5 %.

Raw materials, i.e., 65 parts by weight of water, 1.3 parts by weight of disproportionated potassium salt of rosin acid, 1.7 parts by weight of potassium oleate, 1.5 parts by weight of sodium alkylsulfonate, 0.05 parts by weight of t-dodecylmercaptan, 0.1 parts by weight of polamenthane hydroperoxide, 0.003 parts by weight of iron sulfate, 0.006 parts by weight of sodium ethylenediaminetetraacetic acid, 0.005 parts by weight of sodium formaldehydesulfoxylate, 1.2 parts by weight of potassium sulfate, and 100 parts by weight of butadiene, were reacted by low temperature polymerization at 5 °C. The polymerization conversion was about 60 %. Thus was obtained "water-dispersed latex rubber 2" having a number average particle diameter of 350 nm and a solid concentration of 55 %.

A photosensitive resin composition was obtained by mixing the following components under heat, and by removing water therefrom.

(a) Water-dispersed latex rubber 1 33.6 parts by weight (17 parts by weight in solid content)
(b) Water-dispersed latex rubber 2 14.5 parts by weight (8 parts by weight in solid content)
(c) Phenoxypolyethyleneglycol acrylate      16 parts by weight
(d) A polymerization condensation product of glycerin polyether polyol, succinic anhydride, and 2-hydroxylethyl acrylate      14 parts by weight
(e) Polybutadiene rubber ("Nipol" 1220L, manufactured by ZEON CORPORATION)      20 parts by weight
(f) Nitrile rubber ("Nipol" 1042, manufactured by ZEON CORPORATION)      20 parts by weight
(g) Dimethy benzyl ketal      1 part by weight
(h) Dioctyl phthalate      2 parts by weight
(i) Hydroquinone monomethyl ether      0.1 parts by weight

EXAMPLE 1

The optical density changing layer composition 1 above was applied to the film layer 1 by using a bar coater, and was dried in hot air at 140 °C for 2 minutes to obtain an optical density changing layer 1.5 μm in film thickness.

The film coated with the optical density changing layer composition thus obtained was subjected to a measurement by using a Macbeth densitometer (Model TR-927) together with on orthomatic filter, and an optical density of 2.7 was obtained as a result (the optical density below was measured by a method similar to above).

Then, the photosensitive resin composition 1 was spread on a support, i.e., a polyethylene terephthalate film (250 μm in thickness) coated with a polyester adhesive, and was dried at 60 °C for 3 hours to obtain a photosensitive resin layer having a dry film thickness of 650 μm.

A solution using a 50:50 mixture of ethanol and water as the solvent and containing partially saponified polyvinyl acetate (having a saponification degree of 80 and a polymerization degree of 650) was applied to the photosensitive resin layer in such a manner to obtain a film having a dry film thickness of 1 μm. The film layer previously formed thereon the optical density changing layer was then pressure adhered to the resulting photosensitive resin layer by using roller pressure adhesion.

The photosensitive resin printing plate material thus obtained was mounted on "FX400-AP" (a plate-making machine, manufactured by Toray Engineering Co., Ltd.), and image irradiation was performed on the optical density changing layer by using a semiconductor laser (830 nm in wavelength and 20 μm in beam diameter) at a power output of 800 mJ/cm$^2$ to form an image. The portion irradiated with the laser beam yielded an optical density of 0.3.

Then, by using an exposure machine equipped with 10 chemical lamps, the resulting product was exposed from a distance of 60 mm through the optical density changing layer for 2 minutes. The edge portion of the plate material was covered with a light shielding film so that the edge portion should not be irradiated by the radiation of chemical lamps.

After the exposure, the film layer and the optical density changing layer were peeled off manually from the photosensitive layer. The peel strengthwas measured by using "Tensilon" model UTM-4-100 (manufactured by Orientec Co., Ltd.), at a tensile speed of 200 mm/min, and a value of 3 g/cm was obtained as a result. Thus, it was found that the layers can be peeled off easily (the measurement of peel strength hereinafter was performed in the same manner as above).

Then, development was performed for about 1 minute by using water at 25 °C in a brush type developing machine. As a result, a relief image was formed by washing off the non-crosslinked portions of the photosensitive resin layer.

Thus, a photosensitive resin printing plate having formed thereon the same relief image as that formed on the optical density changing layer was obtained. This plate can be used as a relief printing plate.

EXAMPLE 2

The optical density changing layer composition 2 above was applied to the film layer 1 by using a bar coater, and was dried in hot air at 140 °C for 2 minutes to obtain an optical density changing layer 4.0 $\mu$m in film thickness. The optical density was found to be 4.3.

Then, a photosensitive resin printing plate material was produced in the same manner as the procedure described in Example 1.

The photosensitive resin printing plate material thus obtained was mounted on "FX400-AP" (a plate-making machine, manufactured by Toray Engineering Co., Ltd.), and image irradiation was performed on the optical density changing layer by using a semiconductor laser (830 nm in wavelength and 20 $\mu$m in beam diameter) at a power output of 1000 mJ/cm$^2$ to form an image. The portion irradiated with the laser beam yielded an optical density of 0.2.

Then, exposure and development were performed in the same manner as in Example 1 to obtain a photosensitive resin printing plate. A favorable relief image was obtained as a result.

EXAMPLE 3

A carbon thin film was formed on the film 1 by means of sputtering. Thus was obtained a thin film 300 Angstrom in thickness and having an optical density of 2.6.

Then, a photosensitive resin printing plate material was produced in the same manner as that described in Example 1, and an image was formed on the optical density changing layer by using a semiconductor laser. The optical density of the laser irradiated portion was found to be 0.4.

Thus, a photosensitive resin printing plate was obtained in a production method similar to that employed in Example 1. A favorable relief image was found to be formed.

EXAMPLE 4

A thin film of tellurium was formed on the film layer 3 by vacuum evaporation. Thus was obtained a thin film 280 Angstrom in thickness and having an optical density of 2.7.

Thereafter, a photosensitive resin printing plate material was produced in the same manner as in Example 1, and an image was formed on the optical density changing layer by using a laser radiation in a manner similar to that described in Example 1. The optical density of the laser irradiated portion was found to be 0.4. A photosensitive resin printing plate was obtained in a manner similar to that described in Example 1. A favorable relief image was obtained as a result.

EXAMPLE 5

The optical density changing layer composition 2 was applied to the film layer 3 by using a bar coater, and was dried in hot air at 100 °C for 2 minutes to obtain an optical density changing layer 1.5 $\mu$m in film thickness. The optical density was found to be 2.2.

A photosensitive resin printing plate material was produced in the same manner as in Example 1, and an image was formed on the optical density changing layer by using a laser radiation in a manner similar to that described in Example 1. The optical density of the laser irradiated portion was found to be 0.2. A photosensitive resin printing plate was obtained in a manner similar to that described in Example 1. A favorable relief image was obtained as a result.

EXAMPLE 6

A thin film of a composition containing 75 parts by weight of carbon and 25 parts by weight of zinc was formed on the film layer 3 by vacuum evaporation. Thus was obtained a thin film 150 Angstrom in thickness and having an optical density of 2.3.

A photosensitive resin printing plate material was produced in the same manner as in Example 1, and an image was formed on the optical density changing layer by using a laser radiation in a manner similar to that described in Example 1. The optical density of the laser irradiated portion was found to be 0.3. A photosensitive resin printing plate was obtained in a manner similar to that described in Example 1. A favorable relief image was obtained as a result.

EXAMPLE 7

A photosensitive resin printing plate material comprising a photosensitive resin layer 1.7 mm in thickness was obtained by incorporating the photosensitive resin layer composition 2 between a polyethylene terephthalate film support 125 μm in thickness being coated with a polyester adhesive and a film layer 1 having provided thereon the same optical density changing layer as that described in Example 1, and pressing the resulting structure with a pressing machine heated to 120 °C.

The photosensitive resin printing plate material thus obtained was mounted on "FX400-AP" (a plate-making machine, manufactured by Toray Engineering Co., Ltd.), and image irradiation was performed on the optical density changing layer by using a semiconductor laser (830 nm in wavelength and 20 μm in beam diameter) at a power output of 800 mJ/cm$^2$ to form an image. The portion irradiated with the laser beam yielded an optical density of 0.3.

Then, by using an exposure machine equipped with 10 chemical lamps, the resulting product was exposed from the support side from a distance of 60 mm for 2 minutes. By using the same exposure machine, the photosensitive resin printing plate material was exposed for 6 minutes through the optical density changing layer. The edge portion of the plate material was covered with a light shielding film so that the edge portion should not be irradiated by the radiation of chemical lamps.

The film layer and the optical density changing layer were peeled off manually from the photosensitive resin layer. The peel strength was measured to obtain a value of 2 g/cm. Thus, it was found that the layers can be peeled off easily.

Then, a relief image was formed by developing at 50 °C for about 7 minutes using a brush type developing machine and water containing 0.5 % of a surface activating agent, and by washing off the non-crosslinked portions of the photosensitive resin layer. Then, after drying in a hot air oven heated to 60 °C, a photosensitive resin printing plate was obtained by exposing the resulting plate from the relief side by using an exposure machined above equipped with chemical lamps.

Thus, a photosensitive resin printing plate having formed thereon the same relief image as that formed on the optical density changing layer was obtained. This printing plate can be used in flexographic printing.

EXAMPLE 8

A thermally coloring layer composition for the optical density changing layer 3 was applied to the film layer 1 by using a bar coater, and was dried to obtain a thermally coloring layer 15 μm in thickness.

The composition of the light-to-heat converting substance layer described in the optical density changing layer 3 was further applied to the resulting layer, and was dried to obtain a film having provided thereon a light-to-heat converting substance layer 4 μm in thickness. The film was found to be a favorable green-colored transparent film. The optical density of the film was found to be 0.3.

Then, the photosensitive resin layer composition 1 was spread on a support, i.e., a polyethylene terephthalate film (250 μm in thickness) coated with a polyester adhesive, and was dried at 60 °C for 3 hours to obtain a photosensitive resin layer having a dry film thickness of 650 μm.

A solution using a 50:50 mixture of ethanol and water as the solvent and containing partially saponified polyvinyl acetate (having a saponification degree of 80 and a polymerization degree of 650) was applied to the photosensitive resin layer in such a manner to obtain a film having a dry film thickness of 1 μm. The film layer previously formed thereon the optical density changing layer was then pressure adhered to the resulting photosensitive resin layer by means of roller pressure adhesion.

The photosensitive resin printing plate material thus obtained was mounted on "FX400-AP" (a plate-making machine, manufactured by Toray Engineering Co., Ltd.), and image irradiation was performed on the optical density changing layer by using a semiconductor laser (830 nm in wavelength and 20 μm in beam diameter) at a power output of 800 mJ/cm$^2$ to form an image. The colored portion yielded an optical density of 2.6.

Then, by using an exposure machine equipped with 10 chemical lamps (FL20SBL-360, manufactured by Mitsubishi Electric Corporation) each emitting an ultraviolet radiation, the resulting product was exposed from a distance of 60 mm through the optical density changing layer for 2 minutes. The edge portion of the plate material was covered with a light shielding film so that the edge portion should not be irradiated by the radiation of chemical lamps.

After the exposure, the film layer and the optical density changing layer were peeled off from the photosensitive resin layer. The peel strength was found to be 3 g/cm. Then, development was performed for about 1 minute by using water at 25 °C in a brush type developing machine. As a result, a relief image was formed by washing off the non-crosslinked portions of the photosensitive resin layer. This plate can be used as a relief printing plate.

EXAMPLE 9

A photosensitive resin printing plate was prepared in the same manner as in Example 1; in Example 1, the film comprising a photosensitive resin layer having formed thereon an optical density changing layer was applied after coating a solution of a partially saponified polyvinyl acetate, however, in the present Example, the film was applied without using a solution of a partially saponified polyvinyl acetate.

The photosensitive resin printing plate material thus obtained was image irradiated with a laser in the same manner as in Example 1, and was exposed with a chemical lamp.

Then, the film layer and the optical density changing layer were peeled off manually from the photosensitive resin layer, but was found to be extremely heavy. The peel strength was measured to obtain a value of 23 g/cm.

A favorable relief image was obtained by developing in the same manner as in Example 1.

COMPARATIVE EXAMPLE 1

A film having a dry thickness of 1.1 μm was obtained by applying an optical density changing layer composition 1 on the film layer 1. The optical density of the film layer 1 was found to be 1.7.

A photosensitive resin printing plate material was produced in the same manner as in Example 1, and an image was formed by using a laser radiation. The laser irradiated portion was found to have an optical density of 0.2. Then, a photosensitive resin printing plate was formed in the same manner as in Example 1.

On washing out the"non-cured portion by using a brush type developing machine, the product was found to be unable to develop. This problem is attributed to the low optical density of the optical density changing layer; thus, during the exposure using the chemical lamps, ultraviolet radiation is transmitted through the optical density changing layer as to set the entire photosensitive resin layer.

COMPARATIVE EXAMPLE 2

A photosensitive resin printing plate material was obtained in the same manner as in Example 1, except for using the film layer 2.

Then, a printing plate was processed in the same manner as in Example 1. On observing the relief of the printing plate thus obtained, the relief was found to have smooth edge portion, and that the ink was adhered to the edge portion. Thus, the ink had been printed to the object during printing.

The problem above happened due to the too thick a layer; i.e., presumably, scattering of the light transmitted through the film layer during the exposure using chemical lamps occurred as to cause photocuring of the relief edge.

Industrial Applicability

The present invention relates to a photosensitive resin printing plate material capable of forming relief images of protruded type without using any original image films. Thus, the present invention is favorably used in relief printing and flexographic printing.

**Claims**

1. A photosensitive resin printing plate material comprising a support provided thereon at least a photosensitive resin layer and an optical density changing layer, further having a film layer interposed between the photosensitive resin layer and the optical density changing layer.

2. A photosensitive resin printing plate material as claimed in Claim 1, wherein the film layer has a thickness in a range of 1 to 30 μm.

3. A photosensitive resin printing plate material as claimed in Claim 1 or 2, wherein the optical density changing layer yields an optical density of 2.0 or higher or 0.5 or lower before irradiating a laser radiation thereto, said optical density respectively changing to 0.5 or lower or 2.0 or higher after laser is irradiated thereto.

4. A photosensitive resin printing plate material as claimed in one of Claims 1 to 3, wherein the photosensitive resin layer is provided at a thickness in a range of from 0.1 to 10 mm, and is a layer photocurable by a light having a wavelength in a range of from 300 to 400 nm.

5. A photosensitive resin printing plate material as claimed in one of Claims 1 to 4, wherein a film stripping layer is incorporated between the photosensitive resin layer and the film layer.

6. A method for producing a photosensitive resin printing plate of relief type, comprising at least the following steps in this order,

   a step of forming an image on an optical density changing layer,
   a step of forming a latent image by exposure of the photosensitive resin layer through the image,
   a step of peeling off the film layer and the optical density changing layer from the photosensitive resin layer, and
   a step of developing the photosensitive resin layer.

**EP 1 152 296 A1**

## INTERNATIONAL SEARCH REPORT

| International application No. |
|---|
| PCT/JP00/05911 |

| A. CLASSIFICATION OF SUBJECT MATTER |
|---|
| Int.Cl⁷   G03F7/095, G03F7/11, G03F7/00 |

According to International Patent Classification (IPC) or to both national classification and IPC

| B.   FIELDS SEARCHED |
|---|
| Minimum documentation searched (classification system followed by classification symbols)<br>      Int.Cl⁷   G03F7/095, G03F7/11, G03F7/00 |

Documentation searched other than minimum documentation to the extent that such documents are included in the fields searched

Electronic data base consulted during the international search (name of data base and, where practicable, search terms used)

| C.   DOCUMENTS CONSIDERED TO BE RELEVANT |
|---|

| Category* | Citation of document, with indication, where appropriate, of the relevant passages | Relevant to claim No. |
|---|---|---|
| X | WO, 9403838, A (E.I.DU PONT DE NEMOURS AND COMPANY), 17 February, 1994 (17.02.94) & JP, 7-506201, A   & EP, 654150, A & US, 5262275, A | 1-6 |
| X | JP, 10-198036, A (Konica Corporation), | 1-4,6 |
| Y | 31 July, 1998 (31.07.98)   (Family: none) | 5 |
| X | EP, 803769, A (AGFA-GEVAERT N.V.), | 1-4 |
| Y | 29 October, 1997 (29.10.97) & JP, 10-62976, A   & US, 5922502, A | 5,6 |
| Y | EP, 753415, A (KONICA CORPORATION), 15 January, 1997 (15.01.97) & JP, 9-76652, A   & US, 5698363, A | 1-6 |

☐   Further documents are listed in the continuation of Box C.      ☐   See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 13 November, 2000 (13.11.00) | 28 November, 2000 (28.11.00) |

| Name and mailing address of the ISA/<br>      Japanese Patent Office | Authorized officer |
|---|---|
| Facsimile No. | Telephone No. |

Form PCT/ISA/210 (second sheet) (July 1992)